# EUROPÄISCHE PATENTSCHRIFT

(11) **EP 2 730 675 B1**
(45) Veröffentlichungstag und Bekanntmachung des Hinweises auf die Patenterteilung: **05.08.2015**
(21) Anmeldenummer: 13190306.4
(22) Anmeldetag: 25.10.2013
(51) Int. Cl.: C23C 16/448, C23C 16/455

(54) **Vorrichtung zur Erzeugung eines Gasgemisches**
Device for generating a gas mixture
Dispositif destiné à générer un mélange gazeux

(30) Priorität: 31.10.2012 DE 102012021527
(43) Veröffentlichungstag der Anmeldung: 14.05.2014
(73) Patentinhaber: Dockweiler AG, 19306 Neustadt-Glewe (DE)
(72) Erfinder: Köcher, Torsten, 21465 Reinbek (DE)
(74) Vertreter: Hauck Patentanwaltspartnerschaft mbB

(56) Entgegenhaltungen:
- EP-B1- 1 160 355
- WO-A2-2004/010473
- WO-A2-2007/057631
- DE-A1- 1 557 222
- US-B1- 6 270 839

## Beschreibung

Die vorliegende Erfindung betrifft eine Vorrichtung zur Erzeugung eines Gasgemisches, wie es beispielsweise bei der metallorganischen Gasphasendeposition (MOCVD) in der Halbleitertechnik eingesetzt wird.

Solche Vorrichtungen werden fachsprachlich auch als Bubbler bezeichnet, bei denen ein Trägergas, wie beispielsweise Wasserstoff oder Stickstoff, in eine Reaktionskammer des Bubblers eingebracht wird und auf metallorganische Komponenten, wie beispielsweise Trimethylaluminium (TMA), Trimethylgallium (TMG), Triethylgallium (TEG), Trimethylantimon (TMSb), Dimethylhydrazin (DMHy), Trimethylindium (TMI) und/oder Cyklopentadienylmagnesium (Cp₂Mg) trifft. Bei einem sogenannten Feststoff-Bubbler befinden sich die metallorganischen Komponenten als Feststoff in der Reaktionskammer und das Trägergas wird bei vorgegebener Temperatur und Druck durch den Feststoff in der Reaktionskammer geleitet und nimmt metallorganische Verbindungen auf.

Aus WO 2005/113857 ist ein Feststoff-Blubbler bekannt, bei dem die Reaktionskammer über mehrere Teilkammern verfügt, die seriell von dem Trägergas durchlaufen werden.

Aus DE 10 2007 024 266 A1 ist ein mit Flüssigkeit gefüllter Bubbler bekannt, bei dem über eine Temperaturregelung des zu verdampfenden Mediums der Dampfdruck innerhalb der Reaktionskammer eingestellt werden kann. Das Trägergas wird über eine L-förmige Tauchleitung am Grund der Reaktionskammer eingetragen, wobei die Abströmrichtung des Trägergases von dem Grund der Reaktionskammer fort gerichtet ist.

Aus DE 2004 010 834 U1 ist eine Vorrichtung zur Temperierung eines Gutes in einer zylindrischen Kammer bekannt geworden, bei der in die Kammer eingeleitete Druckluft im Ring kreisförmig umgewälzt wird.

Aus DE 37 08 967 A1 ist eine Vorrichtung zur Erzeugung eines Gasgemisches nach dem Sättigungsverfahren bekannt, bei dem über ein Tauchrohr Trägergas in eine in der Reaktionskammer befindliche Flüssigkeit eingeleitet wird. Für die Reaktionskammer ist ein berührungsloser Füllstandsgeber vorgesehen, der eine Mengendosiereinrichtung für die Flüssigkeit in der Reaktionskammer steuert.

Aus EP 1 160 355 B1 ist ein Verdampfer bekannt geworden, der eine Gaseinlasskammer besitzt, die an ihrem Grund mit einem porösen Abschluss versehen ist, der die Gaseinlasskammer von einer Gasauslasskammer trennt.

Aus DE-AS 15 57 222 ist eine Vorrichtung zum Mischen gasförmiger Stoffe bekannt geworden, die ein Zuführrohr für ein Hauptgas aufweist, in welchem koaxial ein zylindrischer Einsatzkörper angeordnet ist, dessen Außenfläche zusammen mit der Innenfläche des Zuführrohrs einen im Querschnitt ringförmigen Strömungskanal bildet, dem ein Zusatzgas radial von außen zuführbar ist. Für die Zufuhr des Zusatzgases ist ein Ringspalt in dem Zuführrohr vorgesehen, wobei ein Einsatzkörper im Bereich des Ringspalts in Strömungsrichtung sich konisch verengend und in einen Zylinder mit geringerem Außendurchmesser übergehend ausgebildet ist.

Eine Vorrichtung zur Erzeugung eines Gasgemisches wird in der Regel in einer Temperiervorrichtung eingebracht. Die Temperiervorrichtung besitzt ein Medium, wie beispielsweise Wasser, das auf einer exakt vorgegebenen Temperatur gehalten wird. Über die externe Temperiervorrichtung wird u. a. die Temperatur in der Reaktionskammer präzise eingestellt. Die Temperatur in der Reaktionskammer ist entscheidend für die Konzentration von metallorganischen Verbindungen in dem austretenden Gas.

Der Erfindung liegt die Aufgabe zugrunde, eine Vorrichtung zur Erzeugung eines Gasgemisches bereitzustellen, die mit einfachen Mitteln eine exakte Temperierung der Reaktionskammer erlaubt.

Erfindungsgemäß wird die Aufgabe durch eine Vorrichtung mit den Merkmalen aus Anspruch 1 gelöst. Vorteilhafte Ausgestaltungen bilden die Gegenstände der Unteransprüche.

Die erfindungsgemäße Vorrichtung ist vorgesehen und bestimmt zur Erzeugung eines Gasgemisches. Insbesondere handelt es sich um einen Feststoff-Bubbler, in dem ein Trägergas eingeleitet und ein mit metallorganischen Verbindungen angereichertes Ausgangsgas gewonnen wird. Die erfindungsgemäße Vorrichtung besitzt eine ringzylindrische Reaktionskammer, die von einer zylindrischen Innenwand und einer zylindrischen Außenwand begrenzt ist. Die Reaktionskammer ist also erfindungsgemäß durch zwei jeweils zylindrische Wände begrenzt. Ferner besitzt die erfindungsgemäße Vorrichtung einen ringförmigen Kopfabschnitt und einen ringförmigen Bodenabschnitt, über die die zylindrische Innenwand und die zylindrische Außenwand miteinander verbunden sind. Der ringförmige Kopfabschnitt und der ringförmige Bodenabschnitt lassen dabei einen von der Innenwand gebildeten Innenbereich frei. Die erfindungsgemäße Vorrichtung zeichnet sich dadurch aus, dass die Reaktionskammer durch eine zylindrische Innenwand und eine zylindrische Außenwand begrenzt ist und somit eine große Oberfläche zur Umgebung besitzt. Der Innenraum innerhalb der zylindrischen Innenwand ist dabei frei und wird auch von dem Kopfabschnitt und dem Bodenabschnitt der Vorrichtung nicht verschlossen. Wird die erfindungsgemäße Vorrichtung in eine beispielsweise mit Wasser befüllte Temperiervorrichtung eingebraucht, so umströmt das Wasser sowohl die zylindrische Außenwand als auch die zylindrische Innenwand, so dass die Reaktionskammer zwischen Innenwand und Außenwand eine große Kontaktfläche mit dem temperierten Wasser besitzt.

In einer bevorzugten Weiterbildung ist durch den Kopfabschnitt mindestens ein Gaszuführrohr geführt, das eine oder mehrere Austrittsöffnungen für ein zuzuführendes Gas in der zylindrischen Reaktionskammer besitzt. Bevorzugt weist das Zuführrohr einen länglichen Rohrabschnitt und einen ringförmigen Verteilabschnitt auf. Der ringförmige Verteilabschnitt läuft in radialer Richtung, bezogen auf die ringzylindrische Reaktionskammer ganz oder teilweise in dieser um. Der längliche Rohrabschnitt des Zuführrohrs erstreckt sich bevorzugt in axialer Richtung, bezogen auf die ringzylindrische Reaktionskammer.

Für einen gleichmäßigen Austrag des zuzuführenden Gases ist der ringförmige Verteilabschnitt bevorzugt mit einer Vielzahl von in radialer Richtung verteilten Austrittsöffnungen versehen. Dabei hat sich als vorteilhaft herausgestellt, die Austrittsöffnungen auf einer dem Bodenabschnitt zugewandten Seite des ringförmigen Teilabschnitts anzuordnen. Bevorzugt bilden der Rohrabschnitt und der ringförmige Verteilabschnitt einen rechten Winkel zueinander, wobei der ringförmige Verteilabschnitt näher zum Bodenabschnitt als zum Kopfabschnitt der Vorrichtung angeordnet ist, so dass das in die Reaktionskammer eingebrachte Gas einen möglichst langen Weg in der Reaktionskammer zurücklegt.

In einer bevorzugten Weiterbildung der erfindungsgemäßen Vorrichtung ist ein Gasabführrohr durch den Kopfabschnitt geführt, wobei das Gasabführrohr eine oder mehrere Austrittsöffnungen für ein aus der ringzylindrischen Reaktionskammer abzuführendes Gas besitzt. Bevorzugt besitzt das Gasabführrohr eine zentrale Eintrittsöffnung, die näher zum Kopfabschnitt als zum Bodenabschnitt der Vorrichtung angeordnet ist.

In einer zweckmäßigen Ausgestaltung sind die zylindrische Innenwand und die zylindrische Außenwand konzentrisch zueinander angeordnet. Durch die konzentrische Anordnung wird sichergestellt, dass die Reaktionskammer, die als Ringzylinder zwischen der Innenwand und der Außenwand gebildet ist, in radialer Richtung eine konstante Dicke besitzt.

Um einen nach Möglichkeit gleichmäßigen Kontakt der Innenwand mit einem Temperiermedium zu ermöglichen, ist der Innendurchmesser des ringförmigen Kopfabschnitts identisch mit dem Innendurchmesser der zylindrischen Wand. Ebenso ist der Innendurchmesser des ringförmigen Bodenabschnitts mit dem Innendurchmesser der zylindrischen Wand übereinstimmend.

Für eine gleichmäßige Verteilung des in die Reaktionskammer eingebrachten Gases besitzt der Bodenabschnitt bevorzugt einen gewölbten Grund, der radial nach innen von der Reaktionskammer fort gewölbt ist. Bezogen auf die Reaktionskammer ist der gewölbte Grund also nach außen konvex gewölbt.

Eine bevorzugte Ausgestaltung der erfindungsgemäßen Vorrichtung wird anhand eines Beispiels näher erläutert. Es zeigen:
- Fig. 1: einen Feststoff-Bubbler mit seinen Anschlüssen in einer Ansicht von der Seite,
- Fig. 2: den Feststoff-Bubbler aus Fig. 1 in einer Ansicht von oben, ohne die Anschlüsse,
- Fig. 3: einen Schnitt entlang der Linie A-A aus Fig. 2,
- Fig. 4: den Schnitt aus Fig. 3 ohne zylindrische Außenwand und Bodenelement,
- Fig. 5: das Gaszuführrohr in einer Ansicht von der Seite,
- Fig. 6: das Gaszuführrohr in einer Ansicht von unten,
- Fig. 7: einen Schnitt durch den Bodenabschnitt.
- Fig. 8: eine Draufsicht auf den Bodenabschnitt und
- Fig. 9: einen perspektivische Ansicht des Bodenabschnitts.

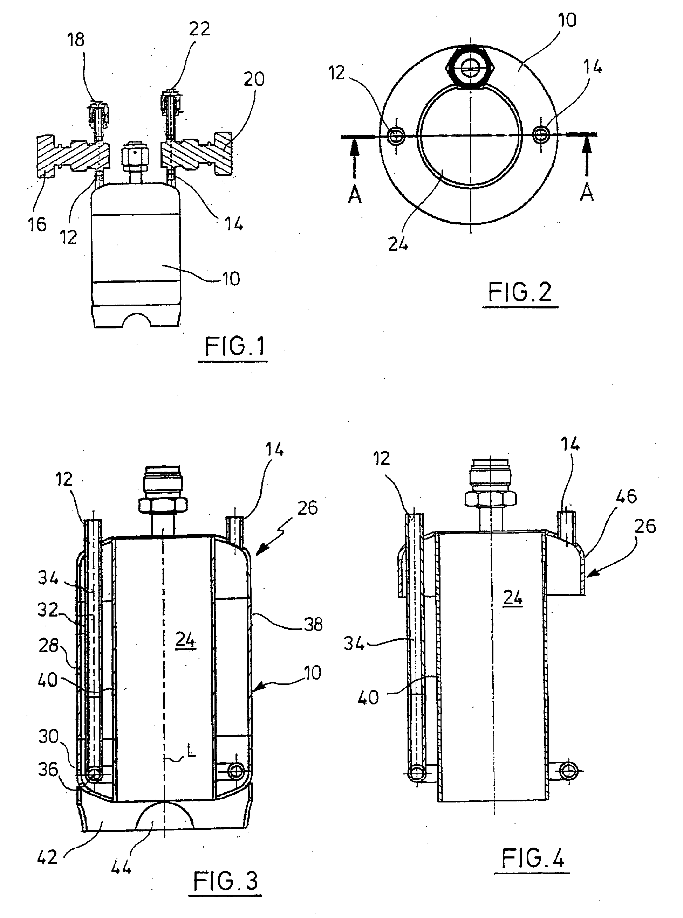

Fig. 1 zeigt eine Ansicht einer Vorrichtung zur Erzeugung eines Gasgemisches in Form eines Feststoff-Bubblers 10. Der Feststoff-Bubbler 10 besitzt eine Zuleitung 12, über die ein Trägergas in die Reaktionskammer zugeführt werden kann und eine Ableitung 14, über die das mit metallorganischen Verbindungen angereicherte Trägergas aus der Reaktionskammer ausgeführt wird. Auf der Zuleitung 12 ist ein schematisch dargestelltes Ventil 16 dargestellt. Die Eingangsleitung des Ventils 16 ist über eine Verschlusskappe 18 verschlossen. Für den Betrieb des Feststoff-Bubblers 10 wird die Verschlusskappe 18 entfernt und mit einer Zuleitung für das Trägergas verbunden. Auch die Gasausgangsleitung 14 ist mit einem Regelventil 20 versehen, dessen Ausgangsleitung über eine Verschlusskappe 22 verschlossen ist.

Im Betrieb des Feststoff-Bubblers 10 wird die Verschlusskappe 22 entfernt und die Ausgangsleitung des Ventils 20 mit der Prozessführung verbunden.

Fig. 2 zeigt eine Draufsicht von oben auf den Feststoff-Bubbler 10, wobei die Ventile von der Zuleitung 12 und der Ableitung 14 entfernt sind. In Fig. 2 ist deutlich zu erkennen, dass der Feststoff-Bubbler 10 insgesamt eine ringzylindrische Form besitzt mit einem zylindrischen Bereich 24, der frei ist. Ringzylindrisch bezeichnet hierbei eine geometrische Form, die zwischen einem innenliegenden Zylinder und einem außenliegenden Zylinder eingeschlossen ist. In dem dargestellten Ausführungsbeispiel handelt es sich hierbei um konzentrisch angeordnete Kreiszylinder, die einen ringzylindrischen Raum mit konstanter radialer Ausdehnung definieren.

Fig. 3 zeigt einen Schnitt durch den Feststoff-Bubbler 10 entlang der Linie A-A aus Fig. 2. In Fig. 3 ist ein dreiteiliger Aufbau des Feststoff-Bubblers zu erkennen mit einem Kopfabschnitt 26. einem mittleren Zylinderabschnitt 28 und einem Bodenabschnitt 30. Durch den Kopfabschnitt 26 ist ein Gaszuführrohr 32 geführt. Das Gaszuführrohr 32 besitzt an seinem aus dem Kopfabschnitt 26 vorstehenden Ende eine Gaseintrittsöffnung 12. Das Gaszuführrohr 32 besitzt einen sich parallel zur Längsachse L erstreckenden länglichen Rohrabschnitt 34, der in einem ringförmigen Verteilabschnitt 36 mündet. Der ringförmige Verteilabschnitt 36 läuft im Bodenabschnitt des Feststoff-Bubblers einmal vollständig um und ist somit als geschlossener Kreis ausgebildet.

Die Gasaustrittsöffnung 14 ist ebenfalls in dem Kopfabschnitt 26 vorgesehen und besitzt einen Anschlussstutzen, der nicht in das Innere des Feststoff-Bubblers hineinreicht.

Wie in Fig. 3 zu erkennen, ist außenseitig zwischen dem Kopfabschnitt 26 und dem Bodenabschnitt 30 eine zylindrische Außenwand 38 angeordnet. Innenseitig ist eine zylindrische Innenwand 40 vorgesehen. Wie deutlich in Fig. 3 zu erkennen, erstreckt sich die zylindrische Innenwand 40 in Längsrichtung bis zum oberen Ende des Kopfabschnitts 26 und bis zum unteren Ende des Bodenabschnitts 30. Die zylindrische Außenwand ist im Gegensatz dazu in axialer Richtung kürzer ausgebildet und erstreckt sich von dem bodenseitigen Ende des Kopfabschnitts bis zum kopfseitigen Ende des Bodenabschnitts 30.

Der Bodenabschnitt 30 besitzt einen umlaufenden Standfuß 42, in dem mehrere Aussparungen 44 vorgesehen sind. Über die Aussparungen 44 ist der von der Innenwand 40 gebildeten Innenraum 24 mit der Umgebung im Bereich des Fußabschnitts 30 verbunden.

Der verwendete Aufbau mit einer sich über die gesamte Längsrichtung erstreckenden zylindrischen Innenwand ist in Fig. 4 noch einmal dargestellt. Fig. 4 zeigt denselben Schnitt wie Fig. 3, jedoch wurden die zylindrische Außenwand 38 und der Bodenabschnitt 30 weggelassen. Deutlich zu erkennen in Fig. 4 ist, dass die Innenwand 40 von einem zylindrischen Rohr gebildet wird, das am Kopfende und an seinem Bodenende offen ist. Am Kopfende des Rohrs 40 ist ein abgewölbtes Blech 46 angesetzt, das mit dem Gaszuführrohr und der Durchführung für das Gaszuführrohr 32 den Kopfabschnitt 26 bildet.

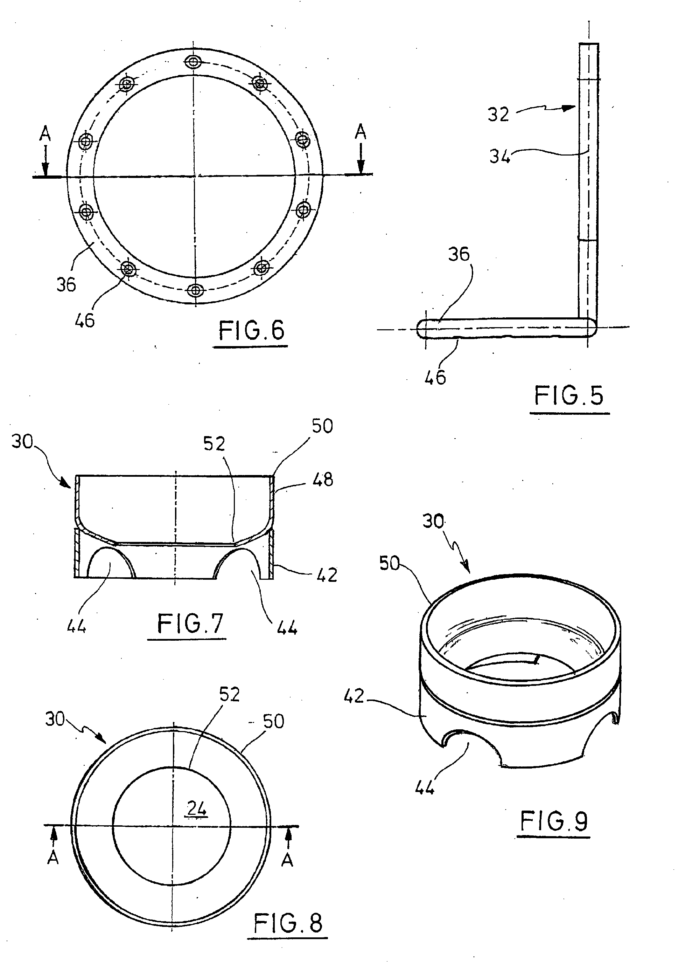

Fig. 5 zeigt das Gaszuführrohr 32 mit seinem länglichen Abschnitt 34 und seinem Verteilabschnitt 36. Der längliche Abschnitt 34 und der Verteilabschnitt 36 besitzen den gleichen Rohrdurchmesser, wobei im Verteilabschnitt 36 auf der von dem länglichen Abschnitt 34 abgewandten Seite Austrittsöffnungen 46 vorgesehen sind.

Fig. 6 zeigt eine Ansicht auf den Verteilabschnitt 36 von unten, in dem die äquidistant angeordneten Gasaustrittsöffnungen 46 zu erkennen sind. Zur Beförderung des Gasaustritts besitzen die Gasaustrittsöffnungen eine sich konisch erweiternde Bohrung, die zum Inneren des Gasverteilrohres 36 hin sich verjüngt. Das Gasverteilrohr 36 ist als geschlossener Kreis ausgebildet.

Fig. 7 zeigt in der Schnittansicht A-A aus Fig. 2 oder Fig. 8 den Bodeabschnitt 30. Der Bodenabschnitt 30 besitzt einen zylindrisch umlaufenden Standfuß 42 mit Ausnehmungen 44. Der Bodenabschnitt 30 wird von einem nach innen gewölbten Bodenblech 48 gebildet. Das Bodenblech 48 wird an seinem zum Kopfende weisenden Rand 50 mit der zylindrischen Außenwand 38 verbunden. Mit seinem radial einwärts stehenden Rand 52 wird das Bodenblech 48 mit der zylindrischen Kennwand 40 verbunden, bevorzugt verschweißt.

Fig. 8 zeigt eine Draufsicht auf das Bodenelement 30 aus Fig. 7, in der die beiden Kanten des Bodenblechs 48 deutlich zu erkennen ist. Ebenfalls zu erkennen ist, dass der radial nach innen stehende Rand 52 den zylindrischen Innenraum 24 begrenzt.

Fig. 9 zeigt eine entsprechende perspektivische Ansicht des Bodenschnitts 30.

### Bezugszeichenliste

- 10: Feststoff-Bubbler
- 12: Zuleitung
- 14: Ableitung
- 16: Ventil
- 18: Verschlusskappe
- 20: Regelventil
- 22: Verschlusskappe
- 24: zylindrischer Bereich
- 26: Kopfabschnitt
- 28: mittlerer Zylinderabschnitt
- 30: Bodenabschnitt
- 32: Gaszuführrohr
- 34: Rohrabschnitt
- 36: Verteilabschnitt / Gasverteilrohr
- 38: zylindrische Außenwand
- 40: zylindrische Innenwand
- 42: umlaufender Standfuß
- 44: Aussparung
- 46: Austrittsöffnungen
- 48: Bodenblech
- 50: Rand
- 52: einwärts stehender Rand

## Patentansprüche

1. Vorrichtung zur Erzeugung eines Gasgemisches, mit einer ringzylindrischen Reaktionskammer, die von einer zylindrischen Innenwand und einer zylindrischen Außenwand sowie von einem ringförmigen Kopfabschnitt (26) und einem ringförmigen Bodenabschnitt (30) begrenzt ist, über die die zylindrische Innenwand (40) und die zylindrische Außenwand (38) miteinander verbunden sind, wobei Kopf- und Bodenabschnitt einen von der Innenwand gebildeten Innenbereich (24) frei lassen.

2. Vorrichtung nach Anspruch 1, **dadurch gekennzeichnet, dass** durch den Kopfabschnitt mindestens ein Gaszuführrohr (34) geführt ist, das einen oder mehrere Austrittsöffnungen (46) für ein zuzuführendes Gas in der ringzylindrischen Reaktionskammer besitzt.

3. Vorrichtung nach Anspruch 2, **dadurch gekennzeichnet, dass** das mindestens eine Zuführrohr einen länglichen Rohrabschnitt (34) und eine ringförmigen Verteilabschnitt (36) aufweist, wobei der ringförmige Verteilabschnitt (36) in radialer Richtung ganz oder teilweise in der Reaktionskammer umläuft.

4. Vorrichtung nach Anspruch 3, **dadurch gekennzeichnet, dass** der ringförmige Verteilabschnitt (36) eine Vielzahl von in radialer Richtung verteilten Austrittsöffnungen (46) besitzt.

5. Vorrichtung nach Anspruch 4, **dadurch gekennzeichnet, dass** die Austrittsöffnungen (46) auf einer dem Bodenabschnitt zugewandten Seite des ringförmigen Verteilabschnitts (36) angeordnet sind.

6. Vorrichtung nach einem der Ansprüche 3 bis 5, **dadurch gekennzeichnet, dass** der längliche Rohrabschnitt und der ringförmige Verteilabschnitt in einem rechten Winkel zueinander stehen.

7. Vorrichtung nach einem der Ansprüche 3 bis 6, **dadurch gekennzeichnet, dass** der ringförmige Verteilabschnitt näher zum Bodenabschnitt als zum Kopfabschnitt angeordnet ist.

8. Vorrichtung nach einem der Ansprüche 1 bis 7, **dadurch gekennzeichnet, dass** durch den Kopfabschnitt (26) hindurch ein Abführrohr (14) geführt ist, das eine oder mehrere Austrittsöffnungen für ein aus der ringzylindrischen Reaktionskammer abzuführendes Gas besitzt.

9. Vorrichtung nach Anspruch 8, **dadurch gekennzeichnet, dass** das Gasabführrohr (14) eine oder mehrere Austrittsöffnungen für ein aus der ringzylindrischen Reaktionskammer abzuführendes Gas besitzt.

10. Vorrichtung nach einem der Ansprüche 8 oder 9, **dadurch gekennzeichnet, dass** die Eintrittsöffnung näher zum Kopfabschnitt als zum Bodenabschnitt angeordnet ist.

11. Vorrichtung nach einem der Ansprüche 1 bis 10, **dadurch gekennzeichnet, dass** die Innenwand (40) und die Außenwand (38) konzentrisch zueinander angeordnet sind.

12. Vorrichtung nach einem der Ansprüche 1 bis 11, **dadurch gekennzeichnet, dass** der Innendurchmesser des ringförmigen Kopfabschnitts dem Innendurchmesser der zylindrischen Innenwand entspricht.

13. Vorrichtung nach einem der Ansprüche 1 bis 12, **dadurch gekennzeichnet, dass** der Innendurchmesser des ringförmigen Bodenabschnitts dem Innendurchmesser der zylindrischen Innenwand entspricht.

14. Vorrichtung nach einem der Ansprüche 1 bis 13, **dadurch gekennzeichnet, dass** der Bodenabschnitt (30) einen gewölbten Grund aufweist, der radial nach innen von der Reaktionskammer fort gewölbt ist.

## Claims

1. A device for generating a gas mixture with a ring-cylindrical reaction chamber that is delimited by a cylindrical inner wall and a cylindrical outer wall as well as an annular head section (26) and an annular floor section (30), via which the cylindrical inner wall (40) and the cylindrical outer wall (38) are connected with each other, wherein the head and floor sections leave free an inner area (24) formed by the inner wall.

2. The device according to claim 1, **characterized in that** at least one gas supply pipe (34) is guided through the head section and possesses one or more outlet openings (46) for a gas to be supplied in the ring-cylindrical reaction chamber.

3. The device according to claim 2, **characterized in that** at least one supply pipe has an elongated pipe section (34) and an angular distribution section (36), wherein the annular distillation section (36) runs around all or part of the inside of the reaction chamber in a radial direction.

4. The device according to claim 3, **characterized in that** the annular distribution section (36) possesses a plurality of outlet openings (46) distributed in a radial direction.

5. The device according to claim 4, **characterized in that** the outlet openings (46) are arranged on a side of the annular distribution section (36) facing the floor section.

6. The device according to one of claims 3 to 5, **characterized in that** the elongated pipe section and the annular distribution section are at a right angle to each other.

7. The device according to one of claims 3 to 6, **characterized in that** the annular distribution section is arranged closer to the floor section than to the head section.

8. The device according to one of claims 1 to 7, **characterized in that** a discharge pipe (14) is guided through the head section (26) and has one or more outlet openings for a gas to be discharged from the ring-cylindrical reaction chamber.

9. The device according to claim 8, **characterized in that** the gas discharge pipe (14) has one or more outlet openings for a gas to be discharged from the ring-cylindrical reaction chamber.

10. The device according to one of claims 8 or 9, **characterized in that** the inlet opening is arranged closer to the head section than to the floor section.

11. The device according to one of claims 1 to 10, **characterized in that** the inner wall (40) and the outer wall (38) are arranged concentrically to each other.

12. The device according to one of claims 1 to 11, **characterized in that** the inner diameter of the annular head section corresponds to the inner diameter of the cylindrical inner wall.

13. The device according to one of claims 1 to 12, **characterized in that** the inner diameter of the annular floor section corresponds to the inner diameter of the cylindrical inner wall.

14. The device according to one of claims 1 to 13, **characterized in that** the floor section (30) has an arched base that is arched radially inward from the reaction chamber.

## Revendications

1. Dispositif pour la production d'un mélange de gaz, avec une chambre de réaction cylindrique annulaire qui est limitée par une paroi intérieure cylindrique et une paroi extérieure cylindrique aussi bien que par une partie de tête (26) annulaire et une partie de fond (30) annulaire à travers lesquelles la paroi intérieure cylindrique (40) et la paroi extérieure cylindrique (38) sont reliées l'une avec l'autre, les parties de tête et de fond laissant libre un espace intérieur (24) formé par la paroi intérieure.

2. Dispositif selon la revendication 1, **caractérisé en ce que** au moins un tube d'alimentation en gaz (34) est guidé à travers la partie de tête, qui a une ou plusieurs ouvertures de sortie (46) pour un gaz devant être alimenté dans la chambre de réaction cylindrique annulaire.

3. Dispositif selon la revendication 2, **caractérisé en ce que** l'au moins un tube d'alimentation a une partie de tube oblongue (34) et une partie de distribution (36) annulaire, la partie de distribution (36) annulaire circulant entièrement ou partiellement dans la chambre de réaction dans la direction radiale.

4. Dispositif selon la revendication 3, **caractérisé en ce que** la partie de distribution (36) annulaire a une pluralité d'ouvertures de sortie (46) distribuées dans la direction radiale.

5. Dispositif selon la revendication 4, **caractérisé en ce que** les ouvertures de sortie (46) sont disposées dans un côté de la partie de distribution (36) annulaire faisant face à la partie de fond.

6. Dispositif selon l'une quelconque des revendications 3 à 5, **caractérisé en ce que** la partie de tube oblongue et la partie de distribution annulaire sont en un angle droit l'une à l'autre.

7. Dispositif selon l'une quelconque des revendications 3 à 6, **caractérisé en ce que** la partie de distribution annulaire est disposée plus proche à la partie de fond qu'à la partie de tête.

8. Dispositif selon l'une quelconque des revendications 1 à 7, **caractérisé en ce que** un tube de refoulement (14) est guidé au travers de la partie de tête (26), qui a une ou plusieurs ouvertures de sortie pour un gaz devant être refoulé de la chambre de réaction cylindrique annulaire.

9. Dispositif selon la revendication 8, **caractérisé en ce que** le tube de refoulement (14) de gaz a une ou plusieurs ouvertures de sortie pour un gaz devant être refoulé de la chambre de réaction cylindrique annulaire.

10. Dispositif selon une des revendications 8 ou 9, **caractérisé en ce que** l'ouverture d'entrée est disposée plus proche à la partie de tête qu'à la partie de fond.

11. Dispositif selon l'une quelconque des revendications 1 à 10, **caractérisé en ce que** la paroi intérieure (40) et la paroi extérieure'(38) sont disposées concentriquement l'une à l'autre.

12. Dispositif selon l'une quelconque des revendications 1 à 11, **caractérisé en ce que** le diamètre intérieur de la partie de tête annulaire correspond au diamètre intérieur de la paroi cylindrique intérieure.

13. Dispositif selon l'une quelconque des revendications 1 à 12, **caractérisé en ce que** le diamètre intérieur de la partie de fond annulaire correspond au diamètre intérieur de la paroi intérieure cylindrique.

14. Dispositif selon l'une quelconque des revendications 1 à 13, **caractérisé en ce que** la partie de fond (30) a un fond courbé, qui est radialement courbé vers l'intérieur loin de la chambre de réaction.
